(19) Europäisches Patentamt
European Patent Office
Office européen des brevets

(11) **EP 4 432 474 A1**

(12) **EUROPEAN PATENT APPLICATION**
published in accordance with Art. 153(4) EPC

(43) Date of publication:
**18.09.2024 Bulletin 2024/38**

(51) International Patent Classification (IPC):
*H01Q 21/08* (2006.01)     *H01Q 1/38* (2006.01)
*H01Q 1/32* (2006.01)     *G01S 7/02* (2006.01)

(21) Application number: **21967483.5**

(22) Date of filing: **13.12.2021**

(86) International application number:
**PCT/CN2021/137451**

(87) International publication number:
**WO 2023/108340 (22.06.2023 Gazette 2023/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **YANG, Xiaopan**
 **Shenzhen, Guangdong 518129 (CN)**
• **TANG, Zhongshan**
 **Shenzhen, Guangdong 518129 (CN)**
• **GAO, Xiang**
 **Shenzhen, Guangdong 518129 (CN)**
• **LIU, Yiting**
 **Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **ANTENNA APPARATUS, RADAR, DETECTION APPARATUS, AND TERMINAL**

(57) Embodiments of this application provide an antenna apparatus, a radar, a detection apparatus, and a terminal, and may be applied to intelligent driving, assisted driving, or autonomous driving. The antenna apparatus includes a first antenna array. The first antenna array includes at least one patch subunit, the at least one antenna unit includes a first antenna unit, and the first antenna unit includes a first patch subunit and a first feeder subunit. The first patch subunit sequentially includes at least two stubs in a first direction, the at least two stubs include a first stub and a second stub, and a length of the first stub in a second direction is less than a length of the second stub in the second direction. The antenna apparatus can implement, on different frequency bands by using the at least two stubs that have different lengths and that are in the patch subunit, a horizontal single peak beam whose radiation signal direction is a normal direction and a horizontal double peak beam whose radiation signal directions are located on two sides of the normal direction. This is applicable to multi-scenario application of a vehicle-mounted millimeter-wave radar, and is simple and easy to implement.

First direction

Second direction

FIG. 6

## Description

## TECHNICAL FIELD

This application relates to the field of sensor technologies, and more specifically, to an antenna apparatus, a radar, a detection apparatus, and a terminal in the field of sensor technologies.

## BACKGROUND

With development of society, intelligent terminals such as an intelligent transportation device, a smart home device, and a robot are gradually entering people's daily lives. Sensors play a very important role in the intelligent terminals. Various sensors, such as a millimeter-wave radar, a lidar, a camera, and an ultrasonic radar, are installed on the intelligent terminal to sense a surrounding environment during movement of the intelligent terminal, collect data, identify and track a moving object, identify static scenarios such as a lane line and a signboard, and perform path planning based on a navigator and map data. The sensor may detect a potential danger in advance and provide assistance or even take a necessary preventive measure, to effectively improve security and comfort of the intelligent terminal.

For example, the intelligent terminal is an intelligent transportation device. The millimeter-wave radar becomes a main sensor of a self-driving system and an assisted driving system because of low costs and a mature technology. Currently, an advanced driver assistance system (advanced driver assistance system, ADAS) includes more than ten functions, where lane change assist (lane change assist, LCA), blind spot detection (blind spot detection, BSD), door open warning (door open warning, DOW), rear cross traffic alert (rear cross traffic alert, RCTA), and parking assist (parking assist, PA) all depend on the millimeter-wave radar. The foregoing different functions have different ranging requirements for the millimeter-wave radar. This undoubtedly increases design complexity of an antenna of the millimeter-wave radar. How to design an antenna of the millimeter-wave radar to meet the requirements of the different functions is always a hot issue.

## SUMMARY

Embodiments of this application provide an antenna apparatus, a radar, a detection apparatus, and a terminal, and can be applied to different function applications.

According to a first aspect, an antenna apparatus and a first antenna array are provided. The first antenna array includes at least one antenna unit, the at least one antenna unit includes a first antenna unit, and the first antenna unit includes a first patch subunit and a first feeder subunit. The first patch subunit sequentially includes at least two stubs in a first direction, and the at least two stubs include a first stub and a second stub. The first stub and the second stub partially overlap, and a length of the first stub in a second direction is less than a length of the second stub in the second direction.

According to this embodiment of this application, the length of the first stub in the second direction is different from the length of the second stub in the second direction, so that the first antenna unit can generate different resonance modes. In addition, the first antenna unit can generate different radiation beams in the different resonance modes. Therefore, this embodiment of this application may be applied to requirements of different functions. In addition, the first antenna unit feeds the first patch subunit by using the first feeder subunit. A structure of the first antenna unit is simple and easy to implement.

With reference to the first aspect, in some implementations of the first aspect, a direction in which the first antenna unit radiates a signal on a first frequency band is a third direction, where the third direction is a normal direction of the first antenna unit; directions in which the first antenna unit radiates signals on a second frequency band are a fourth direction and a fifth direction, where the fourth direction and the fifth direction are respectively located on two sides of the third direction; and the first frequency band is different from the second frequency band.

With reference to the first aspect, in some implementations of the first aspect, the first antenna unit radiates a horizontal single peak beam on the first frequency band, the first antenna unit radiates a horizontal double peak beam on the second frequency band, and the first frequency band is different from the second frequency band.

According to this embodiment of this application, the first antenna unit has one direction on the first frequency band to radiate a signal, and may generate the horizontal single peak beam. The first antenna unit may have two directions on the second frequency band to radiate signals, and may generate the horizontal double peak beam. When the antenna apparatus is disposed at four corners of a vehicle body of a vehicle, on the first frequency band, the direction in which the first antenna radiates a signal is the normal direction. When the antenna apparatus is used as an angle radar, the antenna apparatus may be used to detect a detection target in a left-backward 45° direction the vehicle body, and may be applied to a PA function scenario or the like. On the second frequency band, two directions in which the first antenna unit radiates signals are respectively located on two sides of the normal direction, may be respectively used to detect a detection target on a left side of the vehicle body and a detection target on a rear side of the vehicle body, and may be applied to a BSD, LCA, or DOW function scenario and an RCTA function scenario. In addition, a distance between the detection target and the vehicle may be prompted to a user based on a detection distance.

With reference to the first aspect, in some implementations of the first aspect, a current on the first stub flows in the first direction.

According to this embodiment of this application, the current on the first stub flows in the first direction, so that a horizontal single peak beam in the normal direction can be generated.

With reference to the first aspect, in some implementations of the first aspect, components of a current on the second stub in the second direction are symmetrical in the first direction.

According to this embodiment of this application, the components of the current on the second stub in the second direction are symmetrical in the first direction, so that horizontal double peak beams located on the two sides of the normal direction can be generated.

With reference to the first aspect, in some implementations of the first aspect, the at least two stubs include the first stub, the second stub, and a third stub; and a length of the third stub in the second direction is greater than the length of the first stub in the second direction and less than the length of the second stub in the second direction.

According to this embodiment of this application, the third stub may be configured to adjust impedance of the first patch subunit during radiation, to adjust a radiation characteristic (for example, a frequency of a resonance point of the first antenna unit, or a detection angular domain width of the first antenna unit) of the first antenna unit.

With reference to the first aspect, in some implementations of the first aspect, the length of the first stub in the second direction is L1, $0.35\lambda \leq L1 \leq 0.65\lambda$, and $\lambda$ is an operating wavelength of the antenna apparatus.

With reference to the first aspect, in some implementations of the first aspect, the length of the second stub in the second direction is L2, $0.7\lambda \leq L2 \leq 1.3\lambda$, and $\lambda$ is the operating wavelength of the antenna apparatus.

With reference to the first aspect, in some implementations of the first aspect, the length of the third stub in the second direction is L3, and $0.525\lambda \leq L3 \leq 1.125\lambda$.

With reference to the first aspect, in some implementations of the first aspect, a length of the first patch subunit in the first direction is L4, and $0.5\lambda \leq L4 \leq 1.5\lambda$.

According to this embodiment of this application, the radiation characteristic of the first antenna unit may be adjusted by adjusting the length of the first stub in the second direction, the length of the second stub in the second direction, the length of the third stub in the second direction, and/or the length of the first patch subunit in the first direction. The foregoing parameters may be adjusted based on an actual production or design requirement, to meet a detection requirement.

With reference to the first aspect, in some implementations of the first aspect, the first stub is used to generate a horizontal single peak beam, and/or the second stub is used to generate a horizontal double peak beam.

According to this embodiment of this application, when the first antenna unit radiates on the first frequency band, a radiation beam is mainly generated by a horizontal single peak radiation stub including the first stub and some second stubs. A current on the first stub flows in the first direction, and is in a TM10 mode. This mode corresponds to vertical polarization, and there is only one direction for radiating a signal in this mode. A co-polarization direction in this mode is the normal direction, and a horizontal single peak beam may be generated. When the first antenna unit radiates on the second frequency band, a radiation beam is mainly generated by using the second stub as a horizontal double peak radiation stub. Components of a current on the second stub in the second direction are symmetrical in the first direction, and are in a TM20 mode. This mode corresponds to horizontal polarization, and there are two directions for radiating signals in this mode. The two directions for radiating signals are respectively located on the two sides of the normal direction, and a horizontal double peak beam may be generated.

With reference to the first aspect, in some implementations of the first aspect, the first stub, the second stub, or the third stub is in a shape of a rectangle, an ellipse, a circle, a rhombus, a square, or a trapezoid.

With reference to the first aspect, in some implementations of the first aspect, an edge of the first stub, the second stub, or the third stub is in a shape of a line segment, an arc, an irregular sawtooth line, or an irregular arc whose included angle with the first direction is A, where A ranges from 0° to 180°.

According to this embodiment of this application, a plurality of stubs included in the patch subunit are not necessarily rectangular, or may be in another regular shape, for example, a circle, an ellipse, or a rhombus, or may be in an irregular shape.

With reference to the first aspect, in some implementations of the first aspect, the at least one antenna unit further includes a second antenna unit, where the second antenna unit and the first antenna unit have a same structure. The first antenna unit and the second antenna unit are connected in the first direction.

According to this embodiment of this application, a plurality of antenna units may be sequentially connected in the first direction, to form a first antenna array. The plurality of antenna units in the first antenna array perform feeding in a series-fed manner. A feeding form of the plurality of antenna units is simple, and space occupied by an array including the plurality of antenna units is small, thereby facilitating miniaturization of an antenna array.

With reference to the first aspect, in some implementations of the first aspect, a distance between the first antenna unit and the second antenna unit in the first direction is $0.5 \times N$ first wavelengths, where N is a positive integer.

According to this embodiment of this application, the distance between the first antenna unit and the second antenna unit in the first direction may be adjusted based on an actual production or design requirement, to avoid a case in which a grating lobe occurs in radiation generated by an antenna array including a plurality of antenna units, and consequently, avoid a case in which a location of a measurement target of the antenna apparatus is blurred.

With reference to the first aspect, in some implementations of the first aspect, a central axis of the first stub in the first direction, a central axis of the second stub in the first direction, and/or a central axis of the third stub in the first direction are/is parallel to the second direction.

According to this embodiment of this application, an extension direction (for example, a length direction or a width direction) of the first stub, an extension direction of the second stub, and/or an extension direction of the third stub may be parallel to the second direction.

With reference to the first aspect, in some implementations of the first aspect, the antenna apparatus further includes a second antenna array, where the second antenna array and the first antenna array have a same structure.

According to this embodiment of this application, in actual application, a quantity of antenna arrays in the antenna apparatus may be adjusted based on a design or an actual requirement, to meet a detection requirement. This is not limited in this application.

According to a second aspect, an antenna apparatus production method is provided. The method includes: etching a first antenna array at a first metal layer, where the first antenna array includes at least one antenna unit, the at least one antenna unit includes a first antenna unit, the first antenna unit includes a first patch subunit and a first feeder subunit, the first patch subunit sequentially includes at least two stubs in a first direction, the at least two stubs include a first stub and a second stub, and a length of the first stub in a second direction is less than a length of the second stub in the second direction; bonding the first antenna array to a first surface of a first dielectric layer; and bonding a second surface of the first dielectric layer to a first surface of a first floor layer, where the antenna apparatus is grounded through the first floor layer.

With reference to the second aspect, in some implementations of the second aspect, a direction in which the first antenna unit radiates a signal on a first frequency band is a third direction, where the third direction is a normal direction of the first antenna unit; directions in which the first antenna unit radiates signals on a second frequency band are a fourth direction and a fifth direction, where the fourth direction and the fifth direction are respectively located on two sides of the third direction; and the first frequency band is different from the second frequency band.

With reference to the second aspect, in some implementations of the second aspect, the first antenna unit radiates a horizontal single peak beam on the first frequency band, the first antenna unit radiates a horizontal double peak beam on the second frequency band, and the first frequency band is different from the second frequency band.

With reference to the second aspect, in some implementations of the second aspect, a current on the first stub flows in the first direction.

With reference to the second aspect, in some implementations of the second aspect, components of a current on the second stub in the second direction are symmetrical in the first direction.

With reference to the second aspect, in some implementations of the second aspect, the at least two stubs include the first stub, the second stub, and a third stub; and a length of the third stub in the second direction is greater than the length of the first stub in the second direction and less than the length of the second stub in the second direction.

With reference to the second aspect, in some implementations of the second aspect, the length of the first stub in the second direction is L1, $0.35\lambda \leq L1 \leq 0.65\lambda$, and $\lambda$ is an operating wavelength of the antenna apparatus.

With reference to the second aspect, in some implementations of the second aspect, the length of the second stub in the second direction is L2, $0.7\lambda \leq L2 \leq 1.3\lambda$, and $\lambda$ is the operating wavelength of the antenna apparatus.

With reference to the second aspect, in some implementations of the second aspect, the length of the third stub in the second direction is L3, and $0.525\lambda \leq L3 \leq 1.125\lambda$.

With reference to the second aspect, in some implementations of the second aspect, a length of the first patch subunit in the first direction is L4, and $0.5\lambda \leq L4 \leq 1.5\lambda$.

With reference to the second aspect, in some implementations of the second aspect, the first stub is used to generate a horizontal single peak beam, and/or the second stub is used to generate a horizontal double peak beam.

With reference to the second aspect, in some implementations of the second aspect, the first stub, the second stub, or the third stub is in a shape of a rectangle, an ellipse, a circle, a rhombus, a square, or a trapezoid.

With reference to the second aspect, in some implementations of the second aspect, an edge of the first stub, the second stub, or the third stub is in a shape of a line segment, an arc, an irregular sawtooth line, or an irregular arc whose included angle with the first direction is A, where A ranges from 0° to 180°.

With reference to the second aspect, in some implementations of the second aspect, the at least one antenna unit further includes a second antenna unit, where the second antenna unit and the first antenna unit have a same structure. The first antenna unit and the second antenna unit are connected in the first direction.

With reference to the second aspect, in some implementations of the second aspect, a distance between the first antenna unit and the second antenna unit in the first direction is 0.5×N first wavelengths, where N is a positive integer.

With reference to the second aspect, in some implementations of the second aspect, a central axis of the first stub in the first direction, a central axis of the second stub in the first direction, and/or a central axis of the third stub in the first direction are/is parallel to the second direction.

With reference to the second aspect, in some implementations of the second aspect, the antenna apparatus further includes a second antenna array, where the second antenna array and the first antenna array have a same structure.

According to a third aspect, a radar is provided. The radar includes the antenna apparatus according to any implementation of the first aspect.

With reference to the third aspect, in some implementations of the third aspect, the radar further includes a control chip. The control chip is connected to the antenna apparatus, and the control chip is configured to control the antenna apparatus to transmit or receive a signal.

According to a fourth aspect, a detection apparatus is provided. The detection apparatus includes the antenna apparatus according to any implementation of the first aspect.

According to a fifth aspect, a terminal is provided. The terminal includes the radar according to any implementation of the second aspect.

With reference to the fifth aspect, in some implementations of the fifth aspect, the terminal may be a vehicle, for example, an intelligent transportation device (a vehicle or an unmanned aerial vehicle), a smart home device, a smart manufacturing device, a surveying and mapping device, or a robot. The intelligent transportation device may be, for example, an automated guided vehicle (automated guided vehicle, AGV) or an unmanned transportation vehicle. The terminal may alternatively be a mobile phone (mobile phone), a tablet computer (Pad), a computer with a wireless transceiver function, a virtual reality (virtual reality, VR) terminal, an augmented reality (augmented reality, AR) terminal, a terminal in industrial control (industrial control), a terminal in self driving (self driving), a terminal in a remote medical (remote medical) application, a terminal in a smart grid (smart grid), a terminal in transportation safety (transportation safety), a terminal in a smart city (smart city), a terminal in a smart home (smart home), or the like.

**BRIEF DESCRIPTION OF DRAWINGS**

FIG. 1 is a functional block diagram of a vehicle 100 according to an embodiment of this application;

FIG. 2 is a schematic diagram of an application scenario according to an embodiment of this application;

FIG. 3 is a schematic diagram of directions in which a normal millimeter-wave radar and an angular millimeter-wave radar radiate signals according to an embodiment of this application;

FIG. 4 is a schematic diagram of a structure of a series-fed patch antenna according to an embodiment of this application;

FIG. 5 is a pattern of the patch antenna shown in FIG. 4;

FIG. 6 is a schematic diagram of a structure of an antenna apparatus 200 according to this application;

FIG. 7 is a schematic diagram of a structure of a first antenna unit 210 according to an embodiment of this application;

FIG. 8 is a schematic diagram of composing a pattern according to an embodiment of this application;

FIG. 9 is a schematic diagram of a structure of a first antenna unit 210 according to an embodiment of this application;

FIG. 10(a) to FIG. 10(d) are a schematic diagram of equivalent magnetic current distribution of a patch antenna according to this application;

FIG. 11 is a schematic diagram of current distribution of a patch antenna in a TM10 mode according to an embodiment of this application;

FIG. 12 is a corresponding pattern in the TM10 mode shown in FIG. 11;

FIG. 13 is a schematic diagram of current distribution of a patch antenna in a TM10 mode according to an embodiment of this application;

FIG. 14 is a corresponding pattern in the TM20 mode shown in FIG. 13;

FIG. 15 is a corresponding pattern in different modes according to an embodiment of this application;

FIG. 16 is a simulation diagram of an S parameter of the first antenna unit shown in FIG. 9;

FIG. 17 is a schematic diagram of current distribution when the first antenna unit shown in FIG. 9 generates a horizontal single peak beam;

FIG. 18 is a schematic diagram of current distribution when the first antenna unit shown in FIG. 9 generates a horizontal double peak beam;

FIG. 19 is a pattern of the first antenna unit shown in FIG. 9 on a horizontal plane;

FIG. 20 is a pattern of antenna units in the first antenna array shown in FIG. 6 on a horizontal plane of a first frequency band and a horizontal plane of a second frequency band;

FIG. 21 is a pattern of antenna units in the first antenna array shown in FIG. 6 on a vertical plane of a first frequency band;

FIG. 22 is a pattern of antenna units in the first antenna array shown in FIG. 6 on a vertical plane of a second frequency band;

FIG. 23 is a schematic diagram of another patch subunit according to an embodiment of this application;

FIG. 24 is a schematic diagram of another patch subunit according to an embodiment of this application;
FIG. 25 is a schematic diagram of an antenna apparatus according to an embodiment of this application; and
FIG. 26 shows an antenna apparatus production method according to an embodiment of this application.

## DESCRIPTION OF EMBODIMENTS

The following describes technical solutions of this application with reference to accompanying drawings.

It should be understood that, in this application, an "electrical connection" may be understood as a form in which components are physically in contact and electrically conducted; or may be understood as a form in which different components in a line structure are connected through a physical line that can transmit an electrical signal, such as a printed circuit board (printed circuit board, PCB) copper foil or a conducting wire; or may be understood as a form of performing mid-air conduction in an indirect coupling manner. Both "connection" and "interconnection" may refer to a mechanical connection relationship or a physical connection relationship. For example, A-B connection or A-B interconnection may mean that a fastening component (like a screw, a bolt, or a rivet) exists between A and B, or A and B are in contact with each other and are difficult to be separated.

The following describes some terms in embodiments of this application, to facilitate understanding of a person skilled in the art.

Patch unit: The patch unit is a module that has wireless receiving and transmitting functions in an antenna, for example, clad copper disposed on a PCB.

Feeder: The feeder may also be referred to as a cable, and is used to transmit an electrical signal.

Short range radar, medium range radar, and long range radar: The short range radar, the medium range radar, and the long range radar may be distinguished by a detection distance of a millimeter-wave radar. A detection distance of the short range radar is within 100 m, a detection distance of the medium range radar is between 100 m and 200 m, and a detection distance of the long range radar is greater than 300 m. Generally, the detection distance of the millimeter-wave radar is positively correlated with a gain of an antenna in the millimeter-wave radar. A higher gain indicates a longer detection distance.

Antenna pattern: The antenna pattern is also referred to as a radiation pattern, and is used to describe radiation effect of an antenna. The antenna pattern is a pattern in which a relative field strength (a normalized modulus value) of a radiation field of an antenna varies with a direction at a specific distance from the antenna. Generally, the antenna pattern is represented by using two plane patterns that are vertical to each other in a direction of a radiation signal of the antenna (a direction to which a maximum value of a radiation beam points).

The antenna pattern usually includes a plurality of radiation beams. A radiation beam with a highest radiation intensity is referred to as a main lobe, and small radiation beams beside the main lobe is referred to as side lobes or minor lobes. In the side lobes, a side lobe in an opposite direction of the main lobe is also referred to as a back lobe. In some antenna structures, a radiation lobe, in addition to the main lobe, whose intensity (gain) is similar to that of the main lobe is formed due to in-phase superposition of field intensities in other directions. The radiation lobe is referred to as a grating lobe. In a radar, because a gain of a grating lobe is similar to that of a main lobe, it is difficult to determine whether a measurement target is in a radiation direction of the main lobe or in a radiation direction of the grating lobe. As a result, the measurement target is likely to be confused, and a location of the measurement target is blurred.

Horizontal polarization and vertical polarization of an antenna: At a given point in space, an electrical field strength E (vector) is a unary function of time t. As time goes by, a vector endpoint periodically depicts a track in space. If the track is vertical to the ground (a plane where a floor is located), it is referred to as the vertical polarization. If the track is horizontal to the ground, it is referred to as the horizontal polarization. In addition, because vibration directions of electromagnetic waves in the horizontal polarization and the vertical polarization are vertical to each other, coupling between the horizontal polarization and the vertical polarization is low, and isolation is good.

Co-polarization and cross-polarization of an antenna: The co-polarization of the antenna refers to a movement track of an electrical field vector endpoint in a direction of a radiation signal. Due to a physical structure of the antenna, and the like, an electrical field vector of a far field radiated by the antenna has components in an orthogonal direction of the electrical field vector in addition to a movement in a required direction. This refers to the cross-polarization of the antenna. For example, if the co-polarization of the antenna is horizontal polarization, the cross-polarization is vertical polarization. Generally, a larger difference between the co-polarization and the cross-polarization indicates a better case.

Antenna return loss (S parameter): The antenna return loss may be understood as a ratio of power of a signal reflected back to an antenna port by an antenna circuit to transmit power of the antenna port. A smaller reflected signal indicates a larger signal radiated to space through an antenna and indicates higher radiation efficiency of the antenna. A larger reflected signal indicates a smaller signal radiated to the space through the antenna and indicates lower radiation efficiency of the antenna.

The antenna return loss may be represented by using an S11 parameter, and S11 belongs to one of S parameters. S11 indicates a reflection coefficient, and can indicate superiority or inferiority of transmit efficiency of the antenna. The S11 parameter is usually a negative number. A smaller S11 parameter indicates a smaller antenna return loss and less energy reflected by the antenna. In other words, more energy actually enters the antenna and system efficiency of the antenna is higher. A larger S11 parameter indicates a larger antenna return loss and lower system efficiency of the antenna.

It should be noted that, in engineering, an S11 value of -6 dB is generally used as a standard. When an S11 value of the antenna is less than -6 dB, it may be considered that the antenna can work normally, or it may be considered that transmit efficiency of the antenna is good.

Antenna isolation: The antenna isolation refers to a ratio of a signal transmitted by one antenna and received by another antenna to the transmitted antenna signal. Isolation is a physical quantity used to measure a degree of mutual coupling between antennas. It is assumed that two antennas form a dual-port network. In this case, isolation between the two antennas is S21 and S12 between the antennas. The antenna isolation may be represented by using a parameter S21 and a parameter S12. The parameter S21 and the parameter S12 are usually negative numbers. A smaller S21 parameter and a smaller S12 parameter indicate larger isolation between the antennas and a smaller degree of mutual coupling between the antennas. A larger parameter S21 and a larger parameter S12 indicate smaller isolation between the antennas and a larger degree of mutual coupling between the antennas. The antenna isolation depends on an antenna radiation pattern, an antenna space distance, an antenna gain, and the like.

Ground (floor): The ground may generally refer to at least a part of any ground layer, or ground plate, or ground metal layer in an antenna apparatus, or at least a part of any combination of any ground layer, or ground plate, or ground component. The "ground" can be used to ground components in the antenna apparatus. In an embodiment, the "ground" may be a ground layer of a circuit board of the antenna apparatus, or may be a ground plate formed by a housing of the antenna apparatus. In an embodiment, the circuit board may be a printed circuit board (printed circuit board, PCB), for example, an 8-layer, 10-layer, or 12-layer to 14-layer board having 8, 10, 12, 13, or 14 layers of conductive materials, or an element that is separated by a dielectric layer or insulation layer like glass fiber or polymer and that is electrically insulated. In an embodiment, the circuit board includes a dielectric substrate, a ground layer, and a wiring layer. The wiring layer and the ground layer are electrically connected through a via. In an embodiment, components such as a display, a touchscreen, an input button, a transmitter, a processor, a memory, a battery, a charging circuit, and a system on chip (system on chip, SoC) structure may be installed on or connected to the circuit board, or electrically connected to the wiring layer and/or the ground layer in the circuit board. For example, a radio frequency source is disposed at the wiring layer.

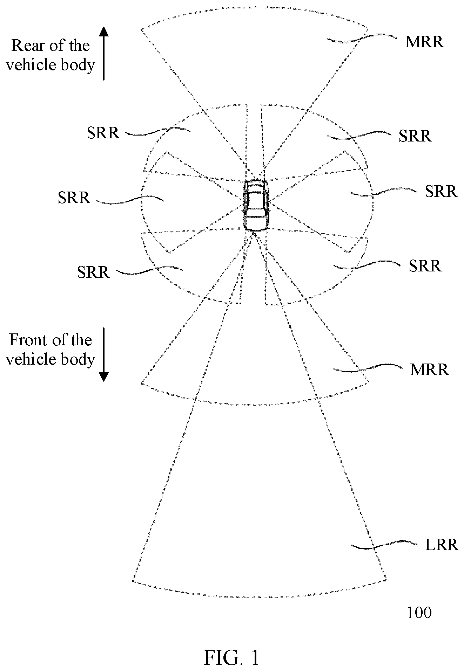

Any of the foregoing ground layer, or ground plate, or ground metal layer is made of a conductive material. In an embodiment, the conductive material may be any one of the following materials: copper, aluminum, stainless steel, brass and alloys thereof, copper foil on insulation laminates, aluminum foil on insulation laminates, gold foil on insulation laminates, silver-plated copper, silver-plated copper foil on insulation laminates, silver foil on insulation laminates and tin-plated copper, cloth impregnated with graphite powder, graphite-coated laminates, copper-plated laminates, brass-plated laminates and aluminum-plated laminates. A person skilled in the art may understand that the ground layer/ground plate/ground metal layer may alternatively be made of another conductive material. FIG. 1 is a schematic diagram of a detection range of a vehicle 100 according to an embodiment of this application.

In millimeter-wave radar equipment, a PCB-based microstrip antenna has advantages of low profile, low costs, easy processing, and easy integration, and therefore, becomes a first choice for a millimeter-wave radar. The millimeter-wave radar may be classified into a long range radar (long range radar, LRR), a medium range radar (mid/medium range radar, MRR), and a short range radar (short range radar, SRR) based on a detection distance of the millimeter-wave radar.

The LRR has a high requirement on a detection distance, but has a relatively low requirement on an angular domain width for detection. The SRR has a low requirement on a detection distance, but has a high requirement on an angular domain width for detection. Requirements of the MRR on a detection distance and an angular domain width may be understood as being between those of the LRR and the SRR. For example, the detection distance of the LRR may be more than 200 meters, and the angular domain width may be ±15°; the detection distance of the MRR may be within 100 meters, and the angular domain width may be ±45°; and the detection distance of the SRR may be within 60 meters, and the angular domain width may be ±80°. In use, different types of millimeter-wave radars may be installed at different positions of a vehicle body based on a function requirement of autonomous driving and a usage status of another sensor. A quantity of the millimeter-wave radars and types of the millimeter-wave radars may be selected based on a requirement. For example, the LRR may be installed on the front of the vehicle body, to serve as a forward radar; the MRR may be installed on the front or the rear of the vehicle body, to serve as a forward radar or a backward radar; and the SRR may be installed on a side of the vehicle body or at four corners of the vehicle body, to serve as a side radar or an angle radar. In addition, the MRR may also be installed on the side of the vehicle body or at the four corners of the vehicle body, and the SRR may also be installed on the front or the rear of the vehicle body.

It should be understood that FIG. 1 provides several possible radar installation positions, which are merely examples. In actual use, more or fewer radars may be selected, and types of the radars may also be adjusted.

The vehicle 100 may be a car, a truck, a motorcycle, a bus, a boat, an airplane, a helicopter, a lawn mower, a recreational vehicle, a playground vehicle, a construction device, a trolley, a golf cart, a train, a handcart, or the like. This is not specifically limited in embodiments of this application.

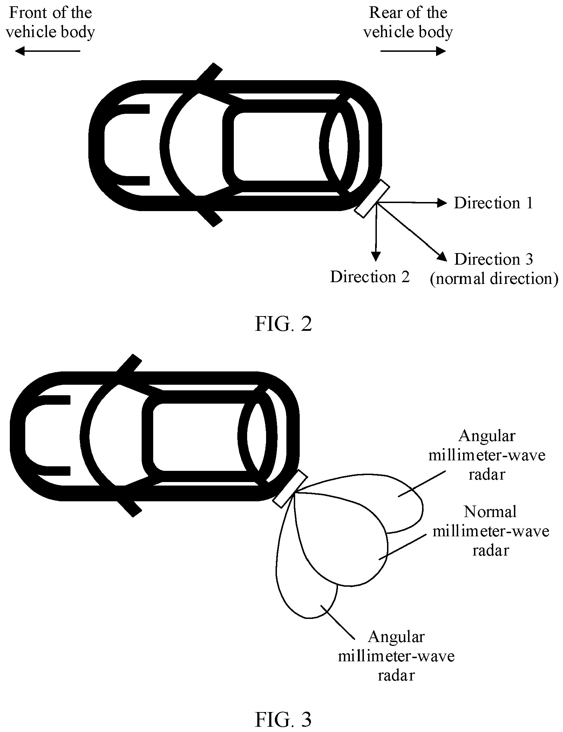

For an angular radar (an angular millimeter-wave radar disposed on a left rear side of the vehicle body is used as an example for description) installed at the four corners of the vehicle body, within a detection range of the angular radar, the angular radar may be applied to different detection scenarios based on different detection angles, as shown in FIG. 2.

Scenario 1: When the detection angle of the angular radar includes a direction 1, the angular radar is used to detect a detection target behind the vehicle body. For example, the angular radar may be applied to a BSD, LCA, or DOW scenario, and may be used to remind the user whether there is a pedestrian or a vehicle in a blind area behind the vehicle, to remind the user whether an operation such as changing a lane of the vehicle or opening a door of the vehicle can be performed.

Scenario 2: When the detection angle of the angular radar includes a direction 2, the angular radar is used to detect a detection target on a left side of the vehicle body. For example, the angular radar may be applied to an RCTA scenario. When the user performs a parking operation, the angular radar may be used to remind the user that there is a vehicle in the direction 2.

Scenario 3: When the detection angle of the angular radar includes a direction 3, the angular radar is used to detect a detection target in a left-backward 45° direction of the vehicle body. For example, the angular radar may be applied to a PA scenario. When the user performs a parking operation, the angular radar may be used to remind the user of a distance between the user and an obstacle in the direction 3.

It should be understood that with improvement of performance (for example, precision of a detection angle) of the millimeter-wave radar, the millimeter-wave radar may provide a more accurate detection result for the user, to improve driving safety of the user. In addition, because the millimeter-wave radar is disposed at the four corners of the vehicle body, the millimeter-wave radar is generally at an angle of 45° with the vehicle body. In Scenario 3, the millimeter-wave radar performs detection in the left-backward 45° direction of the vehicle body, and the direction is a normal direction of the millimeter-wave radar (a direction vertical to a plane on which a radiator of an antenna in the radar is located).

For the foregoing different scenarios, ranging requirements of the millimeter-wave radar are different, and the millimeter-wave radar needs to cover a plurality of different directions at the same time. This undoubtedly increases design complexity of an antenna of the millimeter-wave radar. How to design an antenna of the millimeter-wave radar to meet the requirements of the different functions is always a hot issue.

For the millimeter-wave radar, to cover the foregoing plurality of scenarios, a manner of combining a normal millimeter-wave radar (a direction of a radiation signal is a normal direction) and an angular millimeter-wave radar (a direction of a radiation signal is on two sides of the normal direction, for example, an angle between the radiation signal and the normal direction is ±45°) is usually used, as shown in Figure 3.

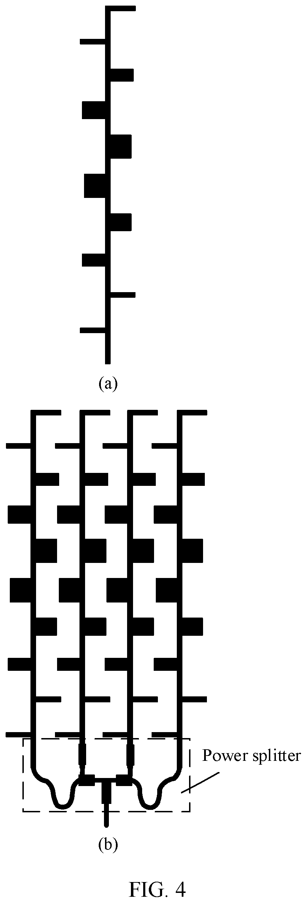

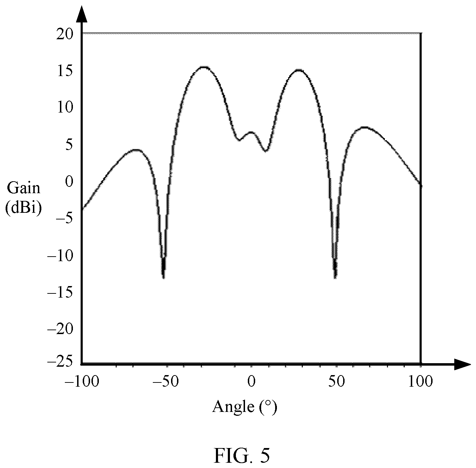

For the normal millimeter-wave radar, a common series-fed patch antenna is used, as shown in (a) in FIG. 4. A direction to which a maximum value of a beam radiated by the normal millimeter-wave radar points is a normal direction (vertical to a plane on which the patch antenna is located). For the angular millimeter-wave radar, a most common implementation is a combination of a multi-column serial-fed patch antenna and a power splitter, as shown in (b) in FIG. 4. It can be learned from a pattern shown in FIG. 5 that the angular millimeter-wave radar has two maximum values (two directions of radiation signals) of radiation beams, and the two maximum values respectively point to -35° and +35° on two sides of the normal direction.

The foregoing millimeter-wave radar jointly uses the normal millimeter-wave radar and the angular millimeter-wave radar to cover a plurality of scenarios. Therefore, there are at least two different antenna forms, and a design is complex. In addition, the angular millimeter-wave radar thereof implements a double peak beam through a multi-column series-fed patch antenna, has a large size in a horizontal direction, and has a difficulty in forming a horizontal array. In addition, grating lobes are likely to occur, resulting in an angle blur.

Embodiments of this application provide an antenna apparatus, a radar, a detection apparatus, and a terminal, and may be applied to intelligent driving, assisted driving, or autonomous driving. The antenna apparatus includes at least one patch subunit, and can implement, on different frequency bands by using at least two stubs that have different lengths and that are in the patch subunit, a horizontal single peak beam whose radiation direction is a normal direction and a horizontal double peak beam whose radiation directions are located on two sides of the normal direction. This is applicable to multi-scenario application of a vehicle-mounted millimeter-wave radar, and is simple and easy to implement.

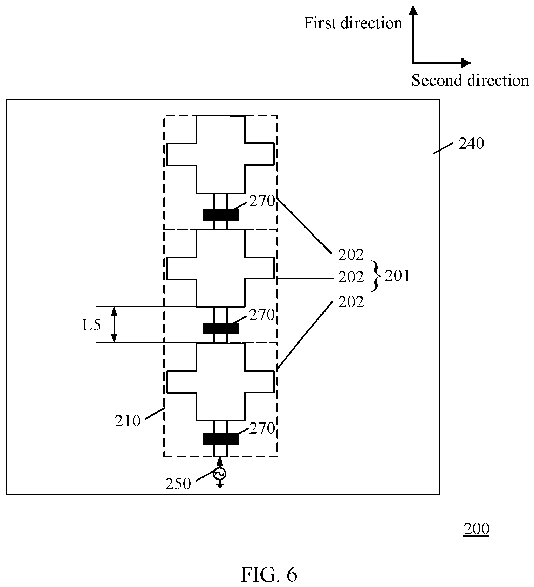

FIG. 6 is a schematic diagram of a structure of an antenna apparatus 200 according to this application.

It should be understood that the antenna apparatus provided in this embodiment of this application may be applied to a 77 GHz millimeter-wave field, or may be applied to a 24 GHz millimeter-wave field. For brevity of description, in this application, only an example in which the antenna apparatus is applied to 77 GHz is used for description, and adjustment may be made in actual application. This is not limited in this application. An application scenario of the antenna apparatus provided in this embodiment is not limited in this application, and may be adjusted based on an actual requirement (for example, a vehicle-mounted millimeter-wave radar or a roadside millimeter-wave radar).

As shown in FIG. 6, the antenna apparatus 200 may include a first antenna array 201, the first antenna array 201 may include at least one antenna unit 202, and the at least one antenna unit 202 may include a first antenna unit 210.

It should be understood that a working principle of an antenna array may be considered as superposition of electromagnetic waves generated by radiation of all antenna units in the array. For a plurality of electromagnetic waves, when the plurality of electromagnetic waves are transmitted to a same area, vector superposition occurs on the electromagnetic waves according to a superposition principle. Therefore, a quantity of antenna units 202 included in the first antenna array 201 may be adjusted based on a requirement, to adjust a radiation characteristic (for example, a detection angle or a detection distance) of the first antenna array 201.

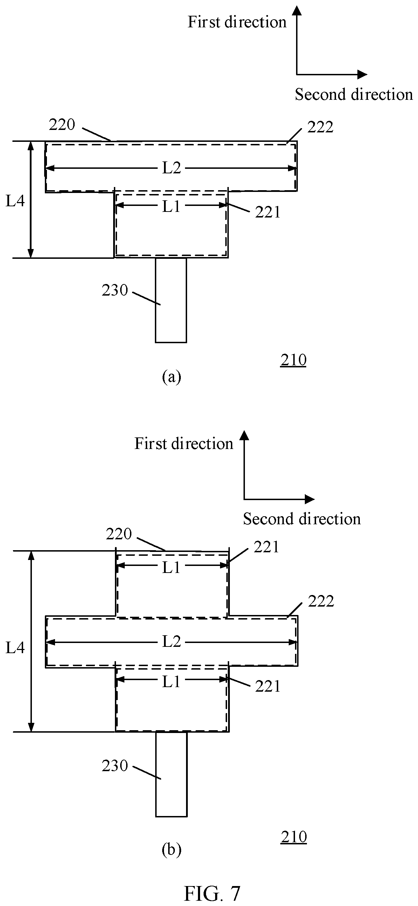

As shown in (a) in FIG. 7, the first antenna unit 210 may include a first patch subunit 220 and a first feeder subunit 230. The first feeder subunit 230 is connected to the first patch subunit 220. The first feeder subunit 230 is configured to feed an electrical signal into the first patch subunit 220, so that the first patch subunit 220 generates a radiation beam. The first patch subunit 220 sequentially includes at least two stubs in a first direction, and the at least two stubs include a first stub 221 and a second stub 222. A length L1 of the first stub 221 in a second direction is less than a length L2 of the second stub 222 in the second direction. The first stub 221 and the second stub 222 may partially overlap. The first direction may be an extension direction of the first feeder subunit 230, a length direction of the first feeder subunit 230, or a width direction of the first stub 221 or the second stub 222. The second direction may be vertical to the first direction. For example, the second direction may be a width direction of the first feeder subunit 230, or may be a length direction of the first stub 221 or the second stub 222.

It should be understood that, in a production process, a plurality of stubs in the first patch subunit 220 may be integrally formed, or may be formed by combining a plurality of patch units. In addition, the length of the first stub 221 in the second direction may be understood as a distance between two points that are farthest from each other in the second direction and that are in the first stub 221. The length of the second stub 222 in the second direction may also be correspondingly understood.

In an embodiment, a first central axis of the first stub 221 in the second direction and a second central axis of the second stub 222 in the second direction are aligned (overlapped), or a first central axis and a second central axis may not be aligned (not overlapped). Adjustment may be performed based on an actual design or production requirement. This is not limited in this application. Lengths of the first stubs 221 on two sides of the first central axis are the same, and lengths of the second stubs on two sides of the second central axis are the same.

In the technical solution provided in this embodiment of this application, the first feeder subunit 230 feeds an electrical signal into the first patch subunit 220. The length of the first stub 221 in the first patch subunit 220 in the second direction is different from the length of the second stub 222 in the second direction, so that the first antenna unit 210 can generate different resonance modes. In addition, the first antenna unit 210 may radiate different radiation beams in the different resonance modes, so that requirements of different functions of the millimeter-wave radar can be met. Therefore, the technology provided in this embodiment of this application may also be applied to another apparatus. For example, the antenna apparatus may be applied to an electronic device. This is not limited in this application.

When radiating a signal on a first frequency band, the first antenna unit 210 has one direction (a direction to which a maximum value of a radiation beam points) for radiating the signal, and may radiate a horizontal single peak beam. When radiating a signal on a second frequency band, the first antenna unit 210 has two directions for radiating the signal, and may radiate a horizontal double peak beam. The first frequency band is different from the second frequency band.

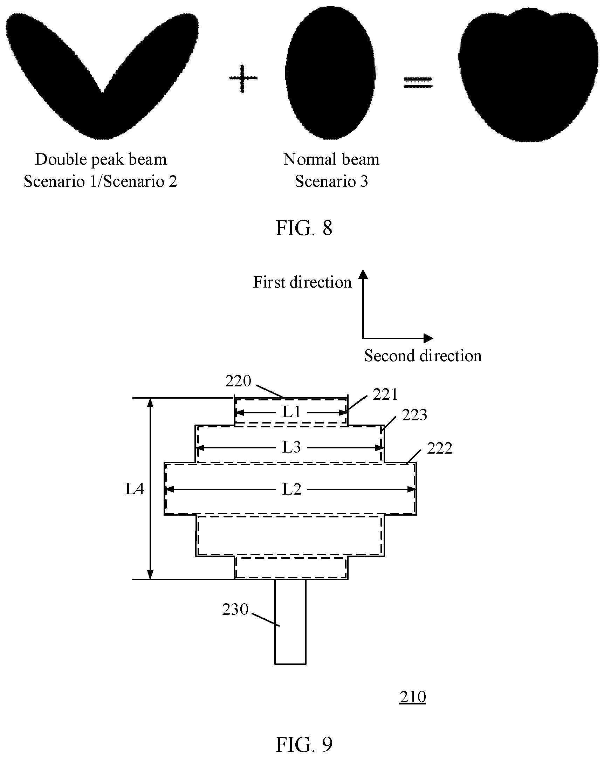

The direction in which the first antenna unit 210 radiates the signal on the first frequency band is a third direction. The third direction is vertical to a direction of a plane on which the first patch subunit 220 is located, and is a normal direction of the first antenna unit 210. When the antenna apparatus is disposed at four corners of a vehicle body of a vehicle and serves as an angle radar, a detection angle of the antenna apparatus includes the direction 3 shown in FIG. 2, may be used to detect a detection target in a left-backward 45° direction of the vehicle body, and may be applied to Scenario 3 described above, for example, applied to a PA function scenario or the like. Directions (a fourth direction and a fifth direction) in which the first antenna unit 210 radiates the signal on the second frequency band are respectively located on two sides of the third direction. Detection angles of the first antenna unit 210 may include the direction 1 and the direction 2 shown in FIG. 2, may be respectively used to detect a detection target on a left side of the vehicle body and a detection target on a rear side of the vehicle body, and may be applied to Scenario 1 and Scenario 2 described above, for example, applied to a B SD, LCA, or DOW function scenario and an RCTA function scenario. The third direction, the fourth direction, and the fifth direction may be located on a same plane, and the plane may be defined as a horizontal plane (for example, the horizontal plane may be a plane formed in the second direction and the third direction), to implement detection at different angles on the same plane. Therefore, according to the antenna apparatus provided in this embodiment of this application, coverage of the plurality of scenarios shown in FIG. 2 may be implemented by using a horizontal single peak normal beam radiated on the first frequency band and a horizontal double peak beam radiated on the second frequency band, as shown in FIG. 8. The horizontal single peak beam may be understood as that the first antenna unit 210 has a single direction for radiating a signal on a plane formed in the second direction and the third direction, and the horizontal double peak beam may be understood as that the first antenna unit 210 has two directions for radiating signals on a plane formed in the second direction and the third direction.

In an embodiment, the first patch subunit 220 may include two first stubs 221, and the two first stubs 221 may be respectively located on two sides of the second stub 222, to increase symmetry of the first patch subunit 220 in the second direction, as shown in (b) in FIG. 7. It should be understood that, as the symmetry of the first patch subunit 220 increases, a radiation characteristic of the first antenna unit 210 is better accordingly.

In an embodiment, the first patch subunit 220 may further include a third stub 223. A length L3 of the third stub 223 in the second direction is greater than the length L1 of the first stub 221 in the second direction and less than the length L2 of the second stub 222 in the second direction, as shown in FIG. 9. The third stub 223 may be configured to adjust impedance of the first patch subunit 220 during radiation, to adjust a radiation characteristic (for example, a frequency of a resonance point of the first antenna unit 210, or an angular domain width of detection of the first antenna unit 210) of the first antenna unit 210.

In an embodiment, a central axis of the first stub 221 in the first direction, a central axis of the second stub 222 in the first direction, and/or a central axis of the third stub 223 in the first direction may be parallel to the second direction. Alternatively, an extension direction (for example, a length direction or a width direction) of the first stub 221, an extension direction of the second stub 222, and/or an extension direction of the third stub 223 may be parallel to the second direction.

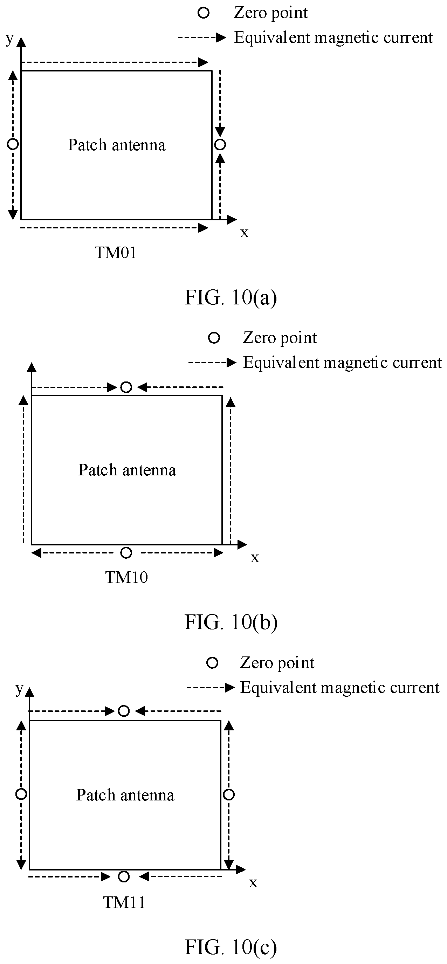

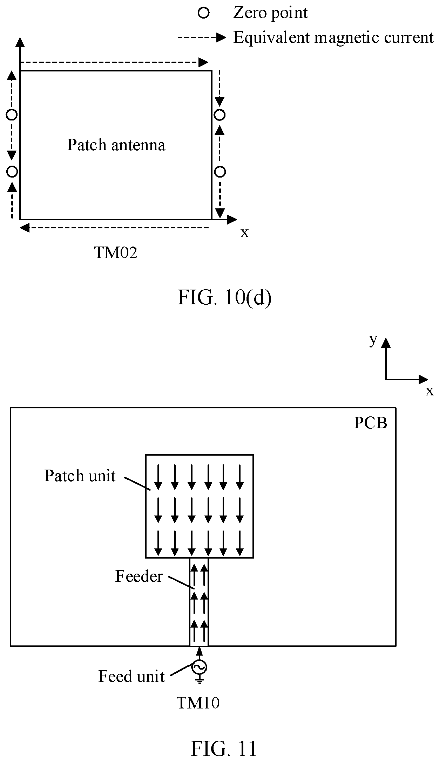

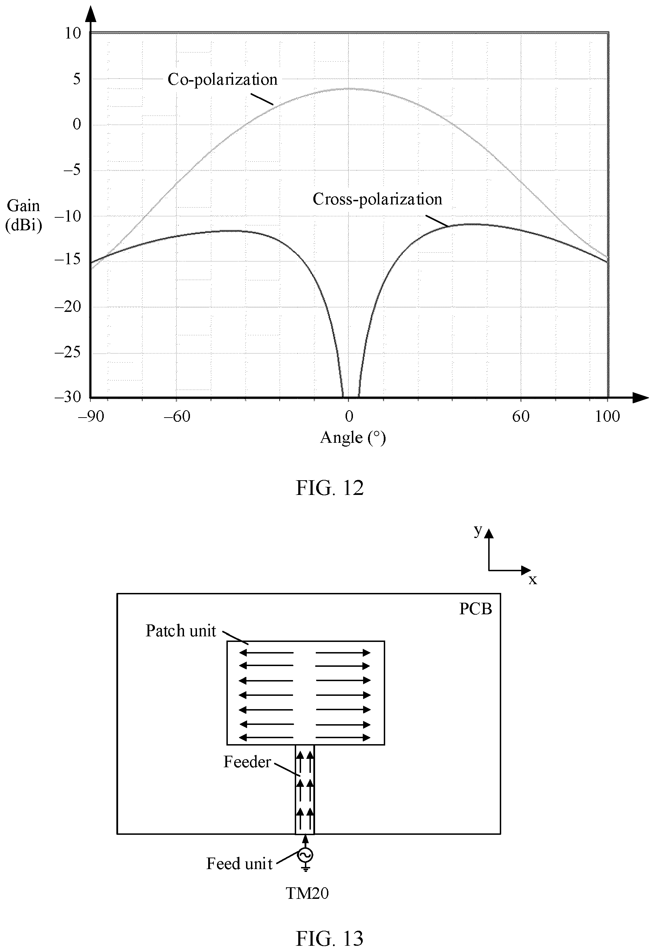

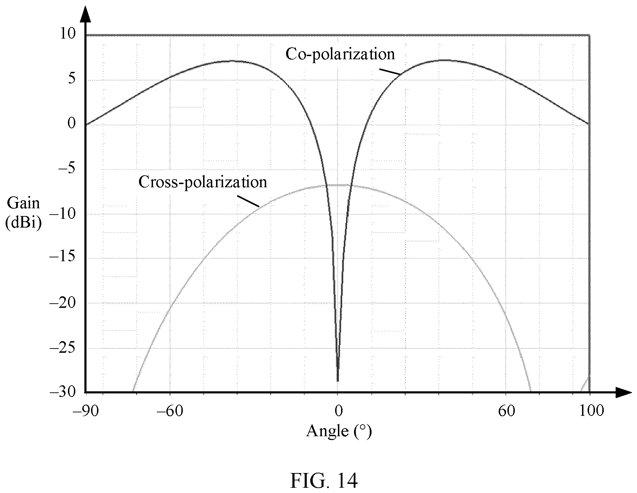

First, an antenna mode in this application is described with reference to FIG. 10(a) to FIG. 10(d) to FIG. 14. FIG. 10(a) to FIG. 10(d) are a schematic diagram of equivalent magnetic current distribution of a patch antenna according to this application. FIG. 11 is a schematic diagram of current distribution of a patch antenna in a TM10 mode according to an embodiment of this application. FIG. 12 is a corresponding pattern in the TM10 mode shown in FIG. 11. FIG. 13 is a schematic diagram of current distribution of a patch antenna in a TM10 mode according to an embodiment of this application. FIG. 14 is a corresponding pattern in the TM20 mode shown in FIG. 13;

FIG. 10(a) to FIG. 10(d) are a schematic diagram of equivalent magnetic current distribution of a patch antenna in several different transverse magnetic mode (Transverse magnetic mode, TM) modes. A pattern and a polarization manner of the patch antenna may be predicted according to the schematic diagram of equivalent magnetic current distribution. The TM mode may be understood as a mode in which radiation generated by the patch antenna has an electrical field component but no magnetic field component in a propagation direction.

In different TM modes, equivalent magnetic current distribution has the following rules.

(1) In a TMmn mode, an equivalent magnetic current has m zero points (because the equivalent magnetic current distribution is similar to sinusoidal distribution, and equivalent magnetic currents on two sides of the zero point is reverse, a reverse point of the equivalent magnetic current is the zero point) in an x-axis direction, and has n zero points in a y-axis direction.

(2) A distance between adjacent zero points in a same direction is $\lambda/2$, and when there is only one zero point in the direction, a length of a patch in the direction is $\lambda/2$, where $\lambda$ is a resonance wavelength of the patch antenna, and may be understood as a wavelength corresponding to a resonance point generated by the patch antenna, or a wavelength corresponding to a center frequency of an operating frequency band of the patch antenna.

For example, FIG. 10(a) is a schematic diagram of equivalent magnetic current distribution of the patch antenna in a TM01 mode. The patch antenna has one zero point in the y-axis direction. Therefore, an electrical length of the patch antenna in the y-axis direction is $\lambda/2$. FIG. 10(b) is a schematic diagram of equivalent magnetic current distribution of the patch antenna in a TM10 mode. The patch antenna has one zero point in the x-axis direction. Therefore, an electrical length of the patch antenna in the x-axis direction is $\lambda/2$. FIG. 10(c) is a schematic diagram of equivalent magnetic current distribution of the patch antenna in a TM11 mode. The patch antenna has one zero point in each of the x-axis direction and the y-axis direction. Therefore, electrical lengths of the patch antenna in the x-axis direction and the y-axis direction are $\lambda/2$. FIG. 10(d) is a schematic diagram of equivalent magnetic current distribution of the patch antenna in a TM02 mode. The patch antenna has two zero points in the y-axis direction. Therefore, an electrical length of the patch antenna in the y-axis direction is $\lambda$.

An electrical length may be represented by multiplying a physical length (namely, a mechanical length or a geometric length) by a ratio of a transmission time period of an electrical or electromagnetic signal in a medium to a time period required when the signal passes through a distance the same as the physical length of the medium in free space. The electrical length may satisfy the following formula:

$$\overline{L} = L \times \frac{a}{b} .$$

L is the physical length, a is the transmission time period of an electrical or electromagnetic signal in a medium, and b is the transmission time period in free space.

Alternatively, the electrical length may be a ratio of a physical length (namely, a mechanical length or a geometric length) to a wavelength of a transmitted electromagnetic wave. The electrical length may satisfy the following formula:

$$\overline{L} = \frac{L}{\lambda_1} .$$

L is the physical length, and $\lambda_1$ is the wavelength of the electromagnetic wave.

As shown in FIG. 11, in the TM10 mode, a current of the patch antenna flows in the y-axis direction. This case corresponds to vertical polarization, and the patch antenna has only one direction for radiating a signal. A co-polarization direction of the patch antenna is a normal direction (a direction vertical to a plane on which the patch antenna is located), and may radiate a horizontal single peak beam, as shown in FIG. 12.

As shown in FIG. 13, in the TM20 mode, currents of the patch antenna on two sides of an extension direction (length direction) of a feeder are symmetrical in the y-axis direction. This case corresponds to horizontal polarization, and the patch antenna has two directions for radiating signals. A co-polarization direction of the patch antenna is located on two sides of the normal direction (vertical to the plane on which the patch antenna is located), and may radiate a horizontal double peak beam, and is at an angle of $\pm 45°$ with the normal direction, as shown in FIG. 14.

In an embodiment, the length L1 of the first stub 221 in the second direction may range from 0.35 to 0.65 first wavelengths ($0.35\lambda \le L1 \le 0.65\lambda$), and the first wavelength $\lambda$ is an operating wavelength of the antenna apparatus 200. The first wavelength may be understood as a wavelength corresponding to a resonance point generated by the first antenna unit 210 in the antenna apparatus 200, or a wavelength corresponding to a center frequency of an operating frequency band of the first antenna unit 210. The first stub 221 may be configured to enable the first antenna unit 210 to work in the TM10 mode when the first antenna unit 210 is on the first frequency, to generate a radiation beam whose radiation direction is the normal direction.

In an embodiment, the length L2 of the second stub 222 in the second direction may range from 0.7 to 1.3 first wavelengths ($0.7\lambda \le L2 \le 1.3\lambda$). The second stub 222 may be configured to enable the first antenna unit 210 to work in the TM20 mode when the first antenna unit 210 is on the second frequency, to generate a radiation beam whose two radiation directions are on the two sides of the normal direction.

In an embodiment, the length L3 of the third stub 223 in the second direction may range from 0.525 to 1.125 first wavelengths ($0.525\lambda \le L3 \le 1.125k$).

In an embodiment, a length L4 of the first antenna unit 220 in the first direction may range from 0.5 to 1.5 first wavelengths ($0.5\lambda \le L4 \le 1.5\lambda$).

It should be understood that the radiation characteristic of the first antenna unit 210 may be adjusted by adjusting the length L1 of the first stub 221 in the second direction, the length L2 of the second stub 222 in the second direction, the length L3 of the third stub 223 in the second direction, and/or the length L4 of the first patch subunit 220 in the first direction. The foregoing parameters may be adjusted based on an actual production or design requirement, to meet a detection requirement.

In an embodiment, the radiation characteristic of the first antenna unit 210 may alternatively be changed by adjusting a length and a width of the first feeder subunit 230. For example, a phase of an electrical signal fed into the first patch subunit 220 may be changed by changing the length of the first feeder subunit 230, and impedance of the first feeder subunit 230 may be changed by changing the width of the first feeder subunit 230. It should be understood that, when the first antenna array 201 includes a plurality of antenna units 202, a phase of an electrical signal fed into a patch subunit of each antenna unit 202 may be adjusted by adjusting a length of a feeder subunit in each antenna unit 202, so that radiation beams generated by the plurality of antenna units 202 in the first antenna array 201 are superimposed, to avoid a case in which mutual cancellation of the radiation beams generated by the plurality of antenna units 202 weakens a radiation characteristic of the antenna apparatus 200. In addition, a detection angle or a detection distance of the first antenna array 201 may be controlled.

Alternatively, in an embodiment, the antenna apparatus 200 may further include at least one matching module 270. The matching module may be disposed on the feeder subunit in the antenna unit 202, and is configured to adjust a phase of an electrical signal fed into the patch subunit in the antenna unit 202, so that radiation beams generated by the plurality of antenna units 202 in the first antenna array 201 are superimposed, to avoid a case in which mutual cancellation of the radiation beams generated by the plurality of antenna units 202 weakens a radiation characteristic of the antenna apparatus 200. In an embodiment, the matching module 270 may be a capacitor or an inductor, or may be a circuit network including a capacitor or an inductor. This is not limited in this application. In addition, when the antenna apparatus 200 includes a plurality of feeder subunits, matching modules 270 disposed on the feeder subunits may be different.

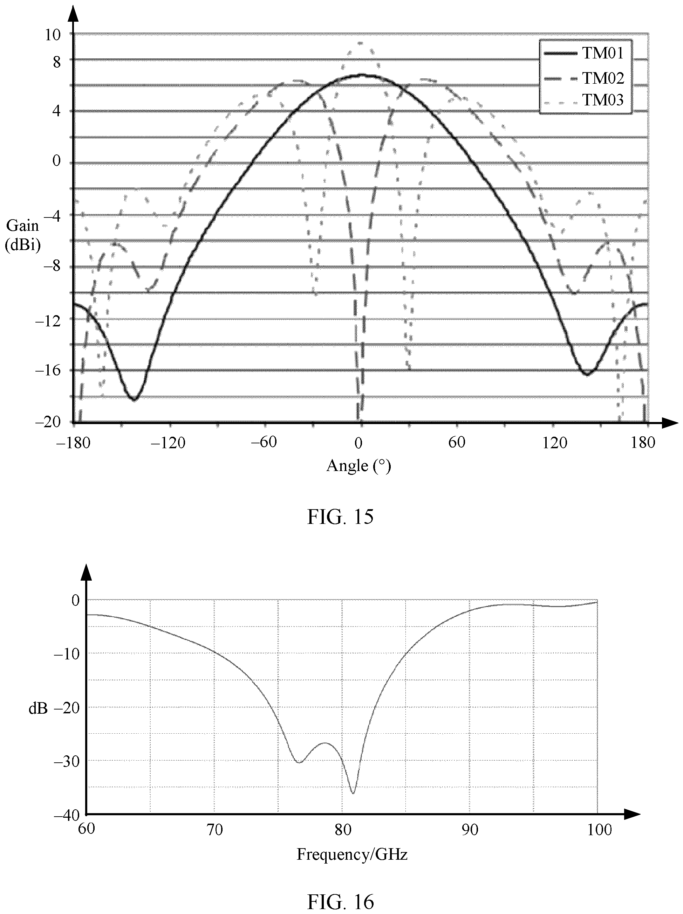

In an embodiment, the first patch subunit 220 may further include a fourth stub. A length of the fourth stub in the second direction is greater than the length L2 of the second stub 222 in the second direction. The length of the fourth stub in the second direction may range from 1.2 to 1.8 first wavelengths. The fourth stub may be configured to enable the first antenna unit 210 to work in a TM30 mode when the first antenna unit 210 radiates on the third frequency, to generate three directions for radiating signals. A pattern of the three directions is shown in FIG. 15, and may be applied to different detection scenarios.

In an embodiment, the antenna apparatus 200 may further include a PCB 240. The first antenna unit 220 may be disposed on a surface of the PCB 240, to form a PCB antenna. It should be understood that the PCB 240 may use a Rogers (Rogers) dielectric board, or may use a hybrid dielectric board of Rogers and FR-4, or the like. Generally, a PCB antenna has advantages of low costs, easy processing, easy integration, and the like.

In an embodiment, the first antenna array 201 may include a plurality of antenna units 202, and the plurality of antenna units 202 each have a same structure, as shown in FIG. 6. The plurality of antenna units 202 are sequentially connected in the first direction, to form the first antenna array 201. It should be understood that, in this embodiment of this application, only an example in which the first antenna array 201 includes three antenna units 202 is used for description. In actual application, a quantity of antenna units included in the first antenna array 201 may be adjusted based on a design or an actual requirement, to meet a detection requirement. This is not limited in this application.

In an embodiment, a distance L5 between patch subunits of any two adjacent antenna units in the plurality of antenna units 202 is $0.5 \times N$ first wavelengths, where N is a positive integer. In other words, a length of a feeder subunit in the antenna unit 202 is $0.5 \times N$ first wavelengths. For brevity of description, in this embodiment of this application, that the distance L5 between the patch subunits of the any two adjacent antenna units in the plurality of antenna units 202 is the first wavelength is used for description, and adjustment may be made based on an actual production or design requirement, to avoid a case in which a grating lobe occurs in radiation generated by the antenna array including the plurality of antenna units 202, and consequently, avoid a case in which a location of a measurement target of the antenna apparatus is blurred

In an embodiment, the antenna apparatus 200 may further include a feed unit 250. The feed unit 250 may be electrically connected to a feeder subunit of the antenna unit 202 close to the feed unit 250, to feed the first antenna array 201. In addition, the plurality of antenna units 202 in the first antenna array 201 perform feeding in a series-fed manner. Therefore, a feeding form of the plurality of antenna units 202 is simple, and space occupied by the array including the plurality of antenna units is small, thereby facilitating miniaturization of an antenna array.

In an embodiment, the feed unit 250 may be different radio frequency channels in a radio frequency chip disposed inside the antenna apparatus 200.

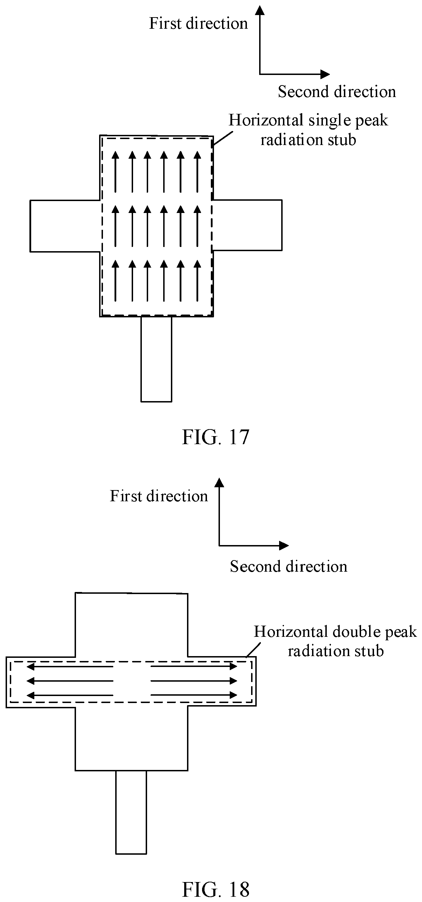

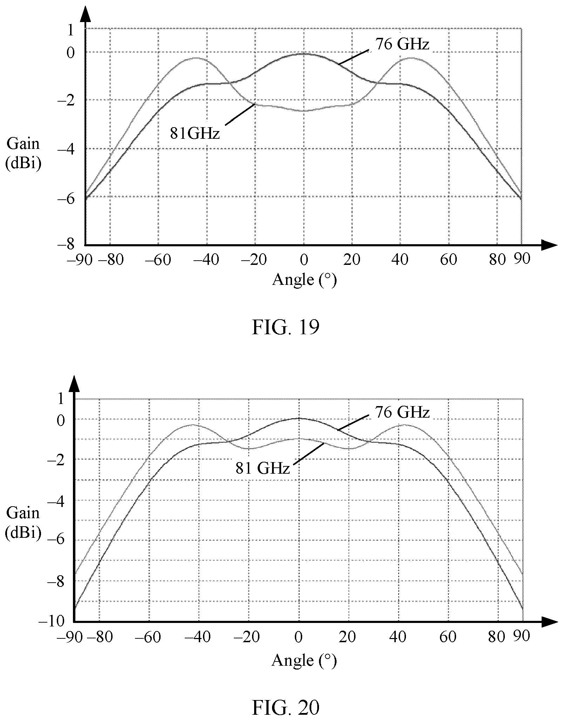

FIG. 16 to FIG. 19 are simulation result diagrams of the first antenna unit shown in FIG. 12. FIG. 16 is a simulation diagram of an S parameter of the first antenna unit shown in FIG. 12. FIG. 17 is a schematic diagram of current distribution when the first antenna unit shown in FIG. 9 generates a horizontal single peak beam. FIG. 18 is a schematic diagram of current distribution when the first antenna unit shown in FIG. 9 generates a horizontal double peak beam. FIG. 19 is a pattern of the first antenna unit shown in FIG. 9 on a horizontal plane. The pattern on the horizontal plane may be understood as a pattern of the first antenna unit on a plane formed in the second direction and the third direction that is vertical to the plane on which the first antenna unit is located.

As shown in FIG. 16, the first antenna unit may generate two resonance points on a frequency band from 60 GHz to 100 GHz. The two resonance points are respectively 76 GHz and 81 GHz, and may correspond to the first frequency band and the second frequency band described above.

As shown in FIG. 17, when the first antenna unit radiates at 76 GHz (the first frequency band), a radiation beam is mainly generated by a horizontal single peak radiation stub including the first stub and some second stubs. In this case, currents on the first stub and some second stubs flow in the first direction, and are in the TM10 mode. In this mode, an electromagnetic wave radiated by the first antenna unit is vertically polarized, and a generated radiation beam has only one radiation direction. The radiation direction of the radiation beam is a normal direction, and the generated radiation beam is a horizontal single peak beam, as shown in FIG. 19.

As shown in FIG. 18, when the first antenna unit radiates at 81 GHz (the second frequency band), a radiation beam is mainly generated by the second stub that serves as a horizontal double peak radiation stub. In this case, components of a current on the second stub in the second direction are symmetrical in the first direction, and are in the TM20 mode. In this mode, an electromagnetic wave radiated by the first antenna unit is horizontally polarized, and a generated radiation beam has two radiation directions. The two radiation directions are respectively located on two sides of the normal direction, and the generated radiation beam is a horizontal double peak beam, and is at an angle of $\pm 45°$ with the normal direction, as shown in FIG. 19.

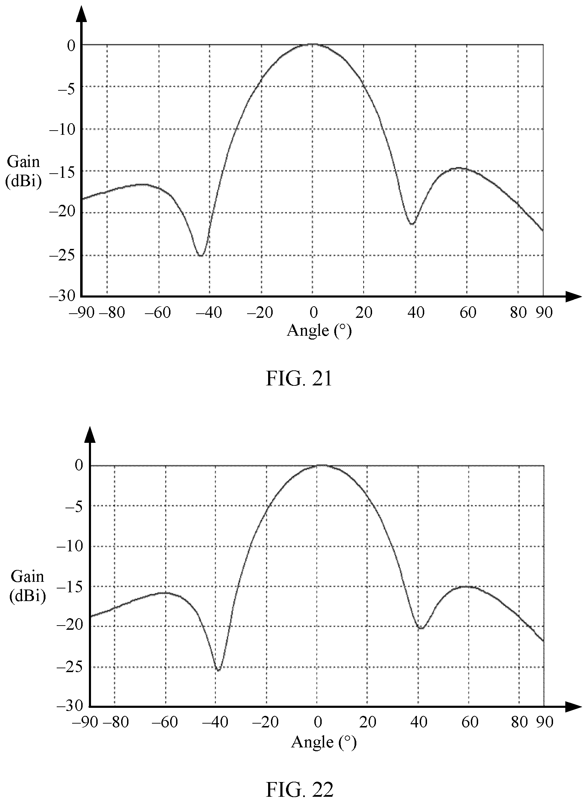

FIG. 20 to FIG. 22 are simulation result diagrams of the first antenna array shown in FIG. 6. FIG. 20 is a pattern of antenna units in the first antenna array shown in FIG. 6 on a horizontal plane of a first frequency band and a horizontal plane of a second frequency band. FIG. 20 is a pattern of antenna units in the first antenna array shown in FIG. 6 on a vertical plane of a first frequency band. FIG. 22 is a pattern of antenna units in the first antenna array shown in FIG. 6 on a vertical plane of a second frequency band.

The pattern on the horizontal plane may be understood as a pattern of the antenna unit in the first antenna array on a plane formed in the second direction and the third direction that is vertical to the plane on which the antenna unit is located. The pattern on the horizontal plane may be understood as a pattern of the antenna unit in the first antenna array on a plane formed in the first direction and the third direction that is vertical to the plane on which the antenna unit is located.

As shown in FIG. 20, the antenna unit in the first antenna array may radiate a horizontal single peak beam and a horizontal double peak beam on the first frequency band and the second frequency band, and may cover the foregoing Scenario 1, Scenario 2, and Scenario 3.

As shown in FIG. 21 and FIG. 22, when the antenna unit in the first antenna array radiates on the first frequency band and the second frequency band, on a vertical plane, a side lobe of the antenna unit is greater than or equal to 14 dBc, and has good radiation performance in a direction for radiating a signal, so that accurate target detection can be implemented.

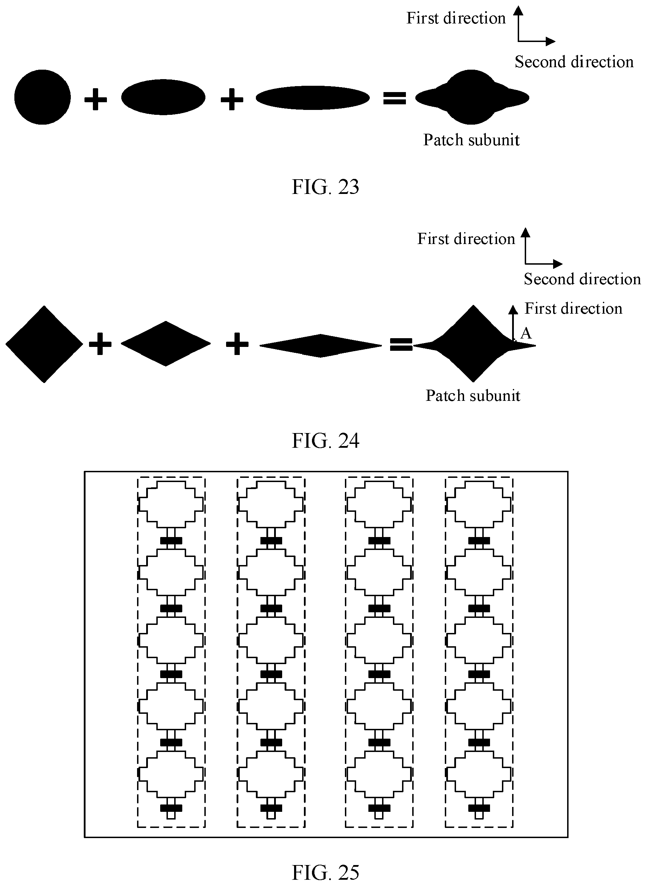

FIG. 23 and FIG. 24 are schematic diagrams of another patch subunit according to an embodiment of this application.

It should be understood that a plurality of stubs included in the patch subunit may not necessarily be rectangular, or may be in another regular shape, for example, a circle, an ellipse, or a rhombus, or may be in an irregular shape. This is not limited in this application. For example, the patch subunit may be considered to be formed by superimposing a plurality of shapes. As shown in FIG. 23 and FIG. 24, each of the plurality of stubs may be in a circle-like shape, and an edge of the stub may include a straight line segment and an arc.

Alternatively, it may be understood as the following: An edge of each of the plurality of stubs is in a shape of a line segment, an arc, an irregular sawtooth, or an irregular arc whose included angle with the first direction is A, where A ranges from 0° to 180°, as shown in Figure 24. This embodiment merely provides some examples. A specific stub shape is not limited in this embodiment.

FIG. 25 is a schematic diagram of an antenna apparatus according to an embodiment of this application.

As shown in FIG. 25, the antenna apparatus includes four antenna arrays with a same structure. It should be understood that, in actual application, a quantity of antenna arrays in the antenna apparatus may be adjusted based on a design or an actual requirement, to meet a detection requirement. This is not limited in this application.

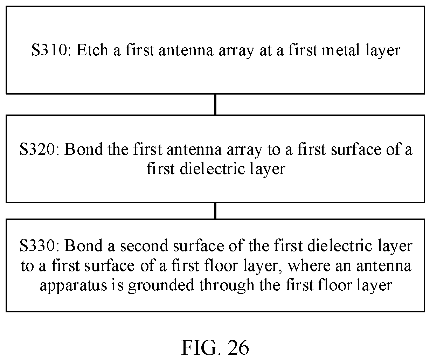

FIG. 26 shows an antenna apparatus production method according to an embodiment of this application.

As shown in FIG. 26, the method may include the following steps. S310: Etch a first antenna array at a first metal layer.

The first antenna array includes at least one antenna unit, the at least one antenna unit includes a first antenna unit, and the first antenna unit includes a first patch subunit and a first feeder subunit. The first patch subunit sequentially includes at least two stubs in a first direction, the at least two stubs include a first stub and a second stub, and a length of the first stub in a second direction is less than a length of the second stub in the second direction.

In an embodiment, the at least two stubs sequentially included in the first patch subunit in the first direction may be integrally formed structures generated by etching the first metal layer, or may be composite structures of a plurality of metal patches separately generated by etching the first metal layer for a plurality of times.

S320: Bond the first antenna array to a first surface of a first dielectric layer.

S330: Bond a second surface of the first dielectric layer to a first surface of a first floor layer, where the antenna apparatus is grounded through the first floor layer.

In an embodiment, a direction in which the first antenna unit radiates a signal on a first frequency band is a third direction, where the third direction is a normal direction of the first antenna unit; directions in which the first antenna unit radiates signals on a second frequency band are a fourth direction and a fifth direction, where the fourth direction and the fifth direction are respectively located on two sides of the third direction; and the first frequency band is different from the second frequency band.

In an embodiment, the first antenna unit radiates a horizontal single peak beam on the first frequency band, the first antenna unit radiates a horizontal double peak beam on the second frequency band, and the first frequency band is different from the second frequency band.

In an embodiment, a current on the first stub flows in the first direction.

In an embodiment, components of a current on the second stub in the second direction are symmetrical in the first direction. For example, the components of the current on the second stub in the second direction are symmetrical along a central axis of the second stub in the first direction.

In an embodiment, the at least two stubs include the first stub, the second stub, and a third stub. A length of the third stub in the second direction is greater than the length of the first stub in the second direction and less than the length of the second stub in the second direction.

In an embodiment, the length of the first stub in the second direction ranges from 0.35 to 0.65 first wavelengths ($0.35\lambda \leq L1 \leq 0.65\lambda$), and the first wavelength is an operating wavelength of the antenna apparatus.

In an embodiment, the length of the second stub in the second direction ranges from 0.7 to 1.3 first wavelengths ($0.7\lambda \le L2 \le 1.3\lambda$), and the first wavelength is the operating wavelength of the antenna apparatus.

In an embodiment, the length of the third stub in the second direction ranges from 0.525 to 1.125 first wavelengths ($0.525\lambda \le L3 \le 1.125\lambda$).

In an embodiment, a length of the first patch subunit in the first direction ranges from 0.5 to 1.5 first wavelengths ($0.5\lambda \le L4 \le 1.5\lambda$).

In an embodiment, the first stub is used to generate a horizontal single peak beam, and/or the second stub is used to generate a horizontal double peak beam.

In an embodiment, the first stub, the second stub, or the third stub is in a shape of a rectangle, an ellipse, a circle, a rhombus, a square, or a trapezoid.

In an embodiment, an edge of the first stub, the second stub, or the third stub is in a shape of a line segment, an arc, an irregular sawtooth line, or an irregular arc whose included angle with the first direction is A, where A ranges from 0° to 180°.

In an embodiment, the at least one antenna unit further includes a second antenna unit, where the second antenna unit and the first antenna unit have a same structure. The first antenna unit and the second antenna unit are connected in the first direction.

In an embodiment, a distance between the first antenna unit and the second antenna unit in the first direction is 0.5×N first wavelengths, where N is a positive integer.

In an embodiment, a central axis of the first stub in the first direction, a central axis of the second stub in the first direction, and/or a central axis of the third stub in the first direction are/is parallel to the second direction.

In an embodiment, the antenna apparatus further includes a second antenna array, where the second antenna array and the first antenna array have a same structure.

An embodiment of this application further provides a detection apparatus. The detection apparatus includes the antenna apparatus described above.

An embodiment of this application further provides a radar. The radar includes the antenna apparatus described above. Further, the radar further includes a control chip, and the control chip is connected to the antenna apparatus. The control chip is configured to control the antenna apparatus to transmit or receive a signal.

An embodiment of this application further provides a terminal. The terminal includes the radar described above. Further, the terminal may be a vehicle, for example, an intelligent transportation device (a vehicle or an unmanned aerial vehicle), a smart home device, a smart manufacturing device, a surveying and mapping device, or a robot. The intelligent transportation device may be, for example, an automated guided vehicle (automated guided vehicle, AGV) or an unmanned transportation vehicle. The terminal may alternatively be a mobile phone (mobile phone), a tablet computer (Pad), a computer with a wireless transceiver function, a virtual reality (virtual reality, VR) terminal, an augmented reality (augmented reality, AR) terminal, a terminal in industrial control (industrial control), a terminal in self driving (self driving), a terminal in a remote medical (remote medical) application, a terminal in a smart grid (smart grid), a terminal in transportation safety (transportation safety), a terminal in a smart city (smart city), a terminal in a smart home (smart home), or the like.

A person of ordinary skill in the art may be aware that units and algorithm steps in the examples described with reference to embodiments disclosed in this specification may be implemented by electronic hardware or a combination of computer software and electronic hardware. Whether the functions are executed by hardware or software depends on a particular application and a design constraint condition that are of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. An antenna apparatus, comprising:

   a first antenna array, wherein
   the first antenna array comprises at least one antenna unit, the at least one antenna unit comprises a first antenna unit, and the first antenna unit comprises a first patch subunit and a first feeder subunit; and
   the first patch subunit sequentially comprises at least two stubs in a first direction, the at least two stubs comprise a first stub and a second stub, and a length of the first stub in a second direction is less than a length of the second stub in the second direction.

2. The apparatus according to claim 1, wherein

a direction in which the first antenna unit radiates a signal on a first frequency band is a third direction, wherein the third direction is a normal direction of the first antenna unit;

directions in which the first antenna unit radiates signals on a second frequency band are a fourth direction and a fifth direction, wherein the fourth direction and the fifth direction are respectively located on two sides of the third direction; and the first frequency band is different from the second frequency band.

3. The apparatus according to claim 1 or 2, wherein

the first antenna unit radiates a horizontal single peak beam on the first frequency band;
the first antenna unit radiates a horizontal double peak beam on the second frequency band; and the first frequency band is different from the second frequency band.

4. The apparatus according to claim 2 or 3, wherein a current on the first stub flows in the first direction.

5. The apparatus according to claim 2 or 3, wherein components of a current on the second stub in the second direction are symmetrical in the first direction.

6. The apparatus according to any one of claims 1 to 5, wherein
the at least two stubs comprise the first stub, the second stub, and a third stub; and a length of the third stub in the second direction is greater than the length of the first stub in the second direction and less than the length of the second stub in the second direction.

7. The apparatus according to any one of claims 1 to 6, wherein
the length of the first stub in the second direction is L1, $0.35\lambda \leq L1 \leq 0.65\lambda$, and $\lambda$ is an operating wavelength of the antenna apparatus.

8. The apparatus according to any one of claims 1 to 7, wherein the length of the second stub in the second direction is L2, $0.7\lambda \leq L2 \leq 1.3\lambda$, and $\lambda$ is the operating wavelength of the antenna apparatus.

9. The apparatus according to any one of claims 6 to 8, wherein
the length of the third stub in the second direction is L3, and $0.525\lambda \leq L3 \leq 1.125\lambda$.

10. The apparatus according to any one of claims 1 to 9, wherein
a length of the first patch subunit in the first direction is L4, and $0.5\lambda \leq L4 \leq 1.5\lambda$.

11. The apparatus according to any one of claims 1 to 10, wherein

the first stub is configured to generate the horizontal single peak beam; and/or
the second stub is configured to generate the horizontal double peak beam.

12. The apparatus according to any one of claims 1 to 11, wherein the first stub, the second stub, or the third stub is in a shape of a rectangle, an ellipse, a circle, a rhombus, a square, or a trapezoid.

13. The apparatus according to any one of claims 1 to 12, wherein an edge of the first stub, the second stub, or the third stub is in a shape of a line segment, an arc, an irregular sawtooth line, or an irregular arc whose included angle with the first direction is A, wherein A ranges from 0° to 180°.

14. The apparatus according to any one of claims 1 to 13, wherein

the at least one antenna unit further comprises a second antenna unit, wherein the second antenna unit and the first antenna unit have a same structure; and
the first antenna unit and the second antenna unit are connected in the first direction.

15. The apparatus according to any one of claims 1 to 14, wherein a distance between the first antenna unit and the second antenna unit in the first direction is $0.5 \times N$ first wavelengths, wherein N is a positive integer.

16. The apparatus according to claim 6 or 7, wherein a central axis of the first stub in the first direction, a central axis of the second stub in the first direction, and/or a central axis of the third stub in the first direction are/is parallel to the second direction.

17. The apparatus according to any one of claims 1 to 16, wherein
the antenna apparatus further comprises a second antenna array, wherein the second antenna array and the first antenna array have a same structure.

18. An antenna apparatus production method, comprising:

etching a first antenna array at a first metal layer, wherein
the first antenna array comprises at least one antenna unit, the at least one antenna unit comprises a first antenna unit, and the first antenna unit comprises a first patch subunit and a first feeder subunit; and

the first patch subunit sequentially comprises at least two stubs in a first direction, the at least two stubs comprise a first stub and a second stub, and a length of the first stub in a second direction is less than a length of the second stub in the second direction;
bonding the first antenna array to a first surface of a first dielectric layer; and
bonding a second surface of the first dielectric layer to a first surface of a first floor layer, wherein the antenna apparatus is grounded through the first floor layer.

19. The method according to claim 18, wherein

a direction in which the first antenna unit radiates a signal on a first frequency band is a third direction, wherein the third direction is a normal direction of the first antenna unit;
directions in which the first antenna unit radiates signals on a second frequency band are a fourth direction and a fifth direction, wherein the fourth direction and the fifth direction are respectively located on two sides of the third direction; and
the first frequency band is different from the second frequency band.

20. The method according to claim 18 or 19, wherein

the first antenna unit radiates a horizontal single peak beam on the first frequency band;
the first antenna unit radiates a horizontal double peak beam on the second frequency band; and
the first frequency band is different from the second frequency band.

21. The method according to claim 19 or 20, wherein a current on the first stub flows in the first direction.

22. The method according to claim 19 or 20, wherein components of a current on the second stub in the second direction are symmetrical in the first direction.

23. The method according to any one of claims 19 to 22, wherein
the at least two stubs comprise the first stub, the second stub, and a third stub; and a length of the third stub in the second direction is greater than the length of the first stub in the second direction and less than the length of the second stub in the second direction.

24. The method according to any one of claims 18 to 23, wherein
the length of the first stub in the second direction is L1, $0.35\lambda \leq L1 \leq 0.65\lambda$, and $\lambda$ is an operating wavelength of the antenna apparatus.

25. The method according to any one of claims 18 to 24, wherein the length of the second stub in the second direction is L2, $0.7\lambda \leq L2 \leq 1.3\lambda$, and $\lambda$ is the operating wavelength of the antenna apparatus.

26. The method according to any one of claims 23 to 25, wherein
the length of the third stub in the second direction is L3, and $0.525\lambda \leq L3 \leq 1.125\lambda$.

27. The method according to any one of claims 18 to 26, wherein
a length of the first patch subunit in the first direction is L4, and $0.5\lambda \leq L4 \leq 1.5\lambda$.

28. The method according to any one of claims 18 to 27, wherein

the first stub is configured to generate the horizontal single peak beam; and/or
the second stub is configured to generate the horizontal double peak beam.

29. The method according to any one of claims 18 to 28, wherein the first stub, the second stub, or the third stub is in a shape of a rectangle, an ellipse, a circle, a rhombus, a square, or a trapezoid.

30. The method according to any one of claims 18 to 29, wherein an edge of the first stub, the second stub, or the third stub is in a shape of a line segment, an arc, an irregular sawtooth line, or an irregular arc whose included angle with the first direction is A, wherein A ranges from 0° to 180°.

31. The method according to any one of claims 18 to 30, wherein

the at least one antenna unit further comprises a second antenna unit, wherein the second antenna unit and the first antenna unit have a same structure; and
the first antenna unit and the second antenna unit are connected in the first direction.

32. The method according to any one of claims 18 to 31, wherein a distance between the first antenna unit and the second antenna unit in the first direction is 0.5×N first wavelengths, wherein N is a positive integer.

33. The method according to claim 23 or 24, wherein a central axis of the first stub in the first direction, a central axis of the second stub in the first direction, and/or a central axis of the third stub in the first direction are/is parallel to the second direction.

34. The method according to any one of claims 18 to 33, wherein
the antenna apparatus further comprises a second antenna array, wherein the second antenna array and the first antenna array have a same structure.

35. A radar, wherein the radar comprises the antenna apparatus according to any one of claims 1 to 17.

36. The radar according to claim 35, wherein the radar further comprises a control chip, the control chip is connected to the antenna apparatus, and the control chip is configured to control the antenna apparatus to transmit or receive a signal.

37. A detection apparatus, wherein the detection apparatus comprises the antenna apparatus according to any one of claims 1 to 17.

38. A terminal, wherein the terminal comprises the radar according to claim 35 or 36.

39. The terminal according to claim 38, wherein the terminal is a vehicle.

Rear of the vehicle body

MRR

SRR

SRR

SRR

SRR

SRR

SRR

Front of the vehicle body

MRR

LRR

100

FIG. 1

Front of the
vehicle body
←

Rear of the
vehicle body
→

Direction 1

Direction 3
(normal direction)

Direction 2

FIG. 2

Angular
millimeter-wave
radar

Normal
millimeter-wave
radar

Angular
millimeter-wave
radar

FIG. 3

(a)

Power splitter

(b)

FIG. 4

FIG. 5

First direction

Second direction

240

270

202

202 } 201

202

L5

270

202

210

270

250

200

FIG. 6

First direction

Second direction

220    222

L2

L4    L1    221

230

210

(a)

First direction

Second direction

220    221

L1

222

L4    L2

L1    221

230

210

(b)

FIG. 7

Double peak beam
Scenario 1/Scenario 2

Normal beam
Scenario 3

FIG. 8

First direction

Second direction

220

221

223

222

L1

L3

L2

L4

230

210

FIG. 9

○  Zero point

------►  Equivalent magnetic current

TM01

FIG. 10(a)

○  Zero point

------►  Equivalent magnetic current

TM10

FIG. 10(b)

○  Zero point

------►  Equivalent magnetic current

TM11

FIG. 10(c)

○    Zero point

- - - -▶   Equivalent magnetic current

Patch antenna

TM02

FIG. 10(d)

y

x

PCB

Patch unit

Feeder

Feed unit

TM10

FIG. 11

FIG. 12

FIG. 13

FIG. 14

FIG. 15

FIG. 16

First direction

Second direction

Horizontal single peak
radiation stub

FIG. 17

First direction

Second direction

Horizontal double peak
radiation stub

FIG. 18

FIG. 19

FIG. 20

FIG. 21

FIG. 22

First direction

Second direction

Patch subunit

FIG. 23

First direction

Second direction

First direction

A

Patch subunit

FIG. 24

FIG. 25

S310: Etch a first antenna array at a first metal layer

S320: Bond the first antenna array to a first surface of a first dielectric layer

S330: Bond a second surface of the first dielectric layer to a first surface of a first floor layer, where an antenna apparatus is grounded through the first floor layer

FIG. 26

## INTERNATIONAL SEARCH REPORT

| International application No. |
|---|
| **PCT/CN2021/137451** |

**A.      CLASSIFICATION OF SUBJECT MATTER**

H01Q 21/08(2006.01)i;  H01Q 1/38(2006.01)i;  H01Q 1/32(2006.01)i;  G01S 7/02(2006.01)i

According to International Patent Classification (IPC) or to both national classification and IPC

**B.      FIELDS SEARCHED**

Minimum documentation searched (classification system followed by classification symbols)

H01Q; G01S

Documentation searched other than minimum documentation to the extent that such documents are included in the fields searched

Electronic data base consulted during the international search (name of data base and, where practicable, search terms used)

CNABS; CNTXT; ENTXTC; CNKI; VEN; ENTXT; USTXT; WOTXT; EPTXT; IEEE: 毫米波, 雷达, 车载, 汽车, 驾驶, 传感器, 贴片, 天线, 宽度, 渐变, 阶梯, 枝节, 第一, 第二, 单峰, 双峰, millimeter wave, radar, on-vehicle, vehicle-mounted, automobile, car, sensor?, patch, antenna?, width, gradual, branch, first, second

**C.      DOCUMENTS CONSIDERED TO BE RELEVANT**

| Category* | Citation of document, with indication, where appropriate, of the relevant passages | Relevant to claim No. |
|---|---|---|
| X | CN 214754187 U (HUIZHOU DESAY SV INTELLIGENT TRANSPORTATION TECHNOLOGICAL INSTITUTE CO., LTD.) 16 November 2021 (2021-11-16) description, paragraphs [0003] and [0027]-[0041], and figures 1 and 2 | 1, 6-10, 12-18, 24-27, 29-39 |
| A | CN 108832289 A (HUNAN NANORADAR TECHNOLOGY CO., LTD.) 16 November 2018 (2018-11-16) entire document | 1-39 |
| A | CN 210379423 U (SHENZHEN LONGHORN AUTOMOBILE ELECTRON EQUIPMENT CO., LTD.) 21 April 2020 (2020-04-21) entire document | 1-39 |
| A | CN 113169448 A (SZ DJI TECHNOLOGY CO., LTD.) 23 July 2021 (2021-07-23) entire document | 1-39 |
| A | JP 2008244520 A (TOYOTA CENTRAL R&D LABS) 09 October 2008 (2008-10-09) entire document | 1-39 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 August 2022** | **26 August 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/137451**

| Patent document cited in search report | | | Publication date (day/month/year) | Patent family member(s) | Publication date (day/month/year) |
|---|---|---|---|---|---|
| CN | 214754187 | U | 16 November 2021 | None | |
| CN | 108832289 | A | 16 November 2018 | None | |
| CN | 210379423 | U | 21 April 2020 | None | |
| CN | 113169448 | A | 23 July 2021 | None | |
| JP | 2008244520 | A | 09 October 2008 | None | |

Form PCT/ISA/210 (patent family annex) (January 2015)